# EUROPÄISCHE PATENTANMELDUNG

(11) **EP 2 876 674 A1**
(43) Veröffentlichungstag der Anmeldung: **27.05.2015**
(21) Anmeldenummer: 13194247.6
(22) Anmeldetag: 25.11.2013
(51) Int. Cl.: H01L 21/67

(54) **Vorrichtung zur Rückgewinnung von Inertgas aus Schleusenkammern**

(71) Anmelder: Roth & Rau AG, 09337 Hohenstein-Ernstthal (DE)
(72) Erfinder: Kehr, Mirko, 09439 Amtsberg OT Dittersdorf (DE)
(74) Vertreter: Kailuweit & Uhlemann Patentanwälte Partnerschaft mbB

(57) **Zusammenfassung**

Verfahren zur Inertgas-Rückgewinnung aus Schleusenkammern, insbesondere für Be- und Entschichtungsmodule in der Halbleiter-Produktion. Dabei wird zur Erzeugung einer Transferatmosphäre in eine Schleusenkammer geleitetes Inertgas einem Puffertank entnommen und nach dem Transfer eines Substrats in eine Bearbeitungskammer erneut in den Puffertank rezykliert. Weiterhin Gegenstand der Erfindung ist eine Anordnung zur Rezyklation von Inertgas, mit der die Rückgewinnung und Wiederverwendung von Inertgas kostengünstig und materialsparend umsetzbar ist.

## Beschreibung

Die Erfindung betrifft eine Vorrichtung sowie ein Verfahren zur Rückgewinnung von Inertgas aus Schleusenkammern. Anwendung findet eine derartige Vorrichtung insbesondere in Anlagen zur Beschichtung oder zum Plasmaätzen von Substraten, während der Herstellung von Dünnschicht-Solarmodulen oder anderen Halbleiter-Produkten.

Die Beschichtung der zumeist Silizium-basierten Substrate mit dünnen funktionellen Schichten erfolgt in der Solarmodul- bzw. Halbleiter-Fertigung in der Regel mittels PECVD - Verfahren (plasma enhanced chemical vapour deposition) oder mit PVD-Verfahren (physical vapour deposition), zudem kann eine Funktionalisierung von Substraten mittels Ionenimplantation erreicht werden. Den eingesetzten Verfahren, bspw. Sputtern, thermisches Verdampfen, Laser- und Ionenstrahlverdampfen, Plasmabeschichtungen, ist dabei gemein, dass sie unter Vakuum- oder dünnen Schutzatmosphären durchgeführt werden. Industriell eingesetzte Durchlaufanlagen weisen daher vakuumdichte Bearbeitungskammern auf, in denen die Beschichtung der Substrate kontinuierlich oder diskontinuierlich erfolgt.

Aus dem Stand der Technik sind zahlreiche Lösungen bekannt, bei denen Substrate eine oder mehrere solcher Bearbeitungskammern durchlaufen. Dabei sind vor, nach und bei mehreren aufeinanderfolgenden Kammern auch zwischen zwei aufeinander folgenden Bearbeitungskammern Schleusenkammern angeordnet, in denen vor der Schleusung in die nächste Bearbeitungskammer die Prozessparameter, insbesondere der Druck und die Zusammensetzung der Atmosphäre, angepasst werden.

Die US 6,382,895 B1 beschreibt eine Einrichtung zum Behandeln von Substraten, mit einer zentralen Verteilungskammer, an deren Umfang über zwei Ebenen eine Vielzahl von Schleusenkammern und eine Vielzahl von Prozesskammern vakuumdicht über Absperrschieber angeflanscht sind. Innerhalb der zentralen Verteilungskammer ist ein Transfermechanismus vorgesehen, der geeignet ist ein Substrat aus den Schleusenkammern zu entnehmen und in eine der Prozesskammern zu transferieren sowie in umgekehrter Richtung wieder zu entnehmen. Die Schleusenkammern können mittels einer Vakuumpumpe evakuiert werden, ein temporärer Aufbau einer Schutzgasatmosphäre erfolgt nicht.

Mit der US 6,176,667 B1 wird ein Multideck-Wafer-Behandlungssystem angegeben, welches mindestens zwei übereinander angeordnete Prozesskammern, eine Wafer-Transferkammer und eine Schleusenkammer aufweist. Jeweils zwei oder mehr Wafer werden gleichzeitig aus einer Vorratskassette in der Schleusenkammer entnommen, einer Prozesskammer zugeführt und nach der Behandlung wieder in der Vorratskassette abgelegt. Die Schleusenkammer kann evakuiert, jedoch nicht mit Inertgas geflutet werden.

Alternativ werden mit dem zu bearbeitenden Substrat bestückte Schleusenkammern vor oder für die Herstellung der gewünschten Arbeitsatmosphäre mit einem Flutgas, i.d.R. Inertgas gespült. Bei diesem zyklischen Füllen der Schleusenkammer wird das Gas üblicherweise aus einem technischen Gasspeicher in die Schleusenkammer ein- und anschließend wieder abgeleitet. Je nach Art und Verschmutzung des Gases schließt sich der Ableitung eine Komprimierung oder Reinigung des Gases an, das daraufhin in einen Abgasspeicher oder in die Umwelt geleitet wird.

Die DE 102 03 833 B4 beschreibt ein Verfahren und eine Vorrichtung zur Differenzdruckregelung an Epitaxiereaktoren, wobei einer Bearbeitungs- bzw. Prozesskammer eine Schleusen- bzw. Wafer-Handling-Kammer vorgeschaltet ist, in der stets ein höherer Druck herrscht als in der Bearbeitungskammer. Dabei wird der Druck in der Schleusenkammer durch eine Saugpumpe eingestellt, die anhand des zwischen Bearbeitungs- und Schleusenkammer bestehenden Druckunterschieds geregelt wird.

In der EP 197 04 67 B1 wird eine Flutungskammer für Beschichtungsanlagen beschrieben, die innerhalb von kurzer Zeit mit einem Inertgas geflutet werden kann. Durch die Verringerung der Flutungszeit soll vorteilhaft die Zykluszeit der Beschichtung herabgesetzt und damit die Wirtschaftlichkeit der Anlage erhöht werden. Als Inertgas wird bevorzugt ein preisgünstiges Gas, insbesondere Stickstoff, verwendet, das in einem Vorratstank gelagert wird. Die Ableitung des Inertgases aus der Flutungskammer ist nicht beschrieben.

Zum Betrieb einer oder mehrerer solcher, aus dem Stand der Technik bekannter Schleusenkammern ist somit immer wieder neues Inertgas notwendig. Um die Menge des eingesetzten Flutgases gering zu halten, werden Schleusenkammern bislang mit möglichst minimalem Volumen ausgeführt. Dies ist hinsichtlich der Bearbeitung größerer Substrate oder der gleichzeitigen Bearbeitung einer Vielzahl von Substraten nachteilig. Zudem muss häufig auf Einbauten in Schleusenkammern verzichtet werden, um Volumen zu sparen.

Aus dem Stand der Technik sind bislang lediglich Verfahren zur Rückgewinnung von Prozessgasen bekannt.

Die DE 42 42 165 A1 beschreibt ein Verfahren zur Wiederbenutzung von Prozessgasen bei der Herstellung von Diamantschichten mit Hilfe eines Plasma-CVD-Verfahrens. Dazu wird Prozessgas nach der Beschichtung aus der Bearbeitungskammer abgesaugt, in seiner Zusammensetzung charakterisiert und entsprechend dieser mit Edelgas vermischt und erneut dem Plasmabetrieb in der Bearbeitungskammer zugeführt.

Auch in der DE 10 2009 037 299 A1 wird eine Behandlungskammer zur thermischen Bearbeitung eines flächigen Substrats beschrieben, wobei die Behandlungs- bzw. Bearbeitungskammer eine Abführeinrichtung zur gezielten Abfuhr des zuvor in die Bearbeitungskammer eingeleiteten Gases aufweist, die Teil eines geschlossenen Gasführungskreislaufs ist. Somit geht keine Wärmeleistung des allein der thermischen Behandlung des Substrats dienenden, ggf. reaktiven oder toxischen, Gases verloren.

Verfahren oder Anlagen, die eine Rezyklieren von Flut- bzw. Inertgas vorsehen oder ermöglichen, sind aus dem Stand der Technik bislang nicht bekannt.

Die Aufgabe der vorliegenden Erfindung ist es, die Nachteile des Standes der Technik zu überwinden und ein Verfahren und eine Anordnung zur Rückgewinnung von Inertgas aus Schleusenkammern vorzuschlagen, mit welchen die Menge des eingesetzten Inertgas, die damit verbundenen Kosten sowie konstruktive Beschränkungen hinsichtlich der Dimensionierung der Schleusenkammern reduziert werden.

Gelöst wird die Aufgabe durch ein Verfahren mit den Merkmalen des Hauptanspruchs sowie durch eine Anordnung gemäß Anspruch 10. Bevorzugte Weiterbildungen sind Gegenstand der jeweils rückbezogenen Unteransprüche.

Die erfindungsgemäße Aufgabe wird gelöst durch ein Verfahren, das durch die Wiederholung der folgenden Verfahrensschritte gekennzeichnet ist:
a) Einschleusen eines Substrates aus einer Atmosphäre A0 in eine Schleusenkammer mit der Atmosphäre A1,
b) gerichtete Gashinleitung zwischen Schleusenkammer und einem Puffer und dadurch Einstellung von Atmosphäre A2 in der Schleusenkammer,
c) Übergabe des Substrates an eine Bearbeitungskammer mit Atmosphäre A3, wobei die Zusammensetzung der Atmosphären A2 und A3 identisch ist,
d) entgegengesetzte Gasrückleitung zwischen Schleusenkammer und Puffer und dadurch Einstellung der Atmosphäre A1 in der Schleusenkammer.

Erfindungsgemäß wird ein Substrat, insbesondere ein flächiges Substrat, aus einer Umgebung der Atmosphäre A0 durch eine Zuführöffnung in eine Schleusenkammer der Atmosphäre A1 eingeschleust. Unter Atmosphäre wird im Sinne dieser Anmeldung die gasförmige Umgebung des Substrats verstanden, die einen abgeschlossenen Raum nahezu vollständig sowie gleichmäßig erfüllt und durch den herrschenden Gasdruck sowie ihre chemische Zusammensetzung charakterisiert ist. Bei der Umgebung mit Atmosphäre A0 handelt es sich bevorzugt um Facility-Räume, bspw. Reinräume, um eine Transportvorrichtung, bspw. einen evakuierten Carrier, oder um eine Bearbeitungskammer. Nachdem das Substrat in die Schleusenkammer eingebracht ist, wird deren Zuführöffnung erneut gasdicht verschlossen.

Anschließend erfolgt eine gerichtete Gashinleitung zwischen Schleusenkammer und Puffer, bevorzugt einem gasdichten Puffertank, wobei eine gerichtete Gasleitung von der Schleusenkammer zu dem Puffertank oder von dem Puffertank zu der Schleusenkammer erfolgt. Unter gerichteter Gashinleitung wird hierbei eine Gasleitung verstanden, bei der ein Gas gezielt verfrachtet wird, wobei Strömungsziel und Strömungsgeschwindigkeit der Gasströmung einstellbar und Leck- oder Rückströme nahezu vollständig vermeidbar sind. Durch die gerichtete Gashinleitung wird in der Schleusenkammer die Atmosphäre A1 nahezu vollständig durch die Atmosphäre A2 ersetzt.

Sobald in der Schleusenkammer die gewünschte Atmosphäre A2 eingestellt ist, erfolgt mittels einer gasdicht verschließbaren Verbindungsöffnung die Übergabe des Substrats an eine Bearbeitungskammer. In der Bearbeitungskammer herrscht die Atmosphäre A3, die eine zur Atmosphäre A2, zumindest annähernd, identische chemische Zusammensetzung aufweist und bei der Bearbeitung des Substrats in der Bearbeitungskammer beibehalten wird.

Im letzten, für das erfindungsgemäße Verfahren wesentlichen Schritt, wird das zuvor durch gerichtete Gashinleitung von der Schleusenkammer zum Puffertank oder vom Puffertank zur Schleusenkammer verfrachtete Gas durch entgegengesetzte Gasrückleitung vom Puffertank zur Schleusenkammer oder von der Schleusenkammer zum Puffertank geleitet. Bei der entgegengesetzten Gasrückleitung handelt es sich ebenfalls um eine gerichtete Gasleitung, durch die in der Schleusenkammer die Atmosphäre A2 nahezu vollständig durch Atmosphäre A1 ersetzt wird.

Das erfindungsgemäße Verfahren ermöglicht vorteilhaft den zyklischen Austausch der in einer Schleusenkammer und in einem verbundenen Puffertank befindlichen Atmosphären. Somit ist nicht für jede Einstellung der Atmosphäre A1 und/oder A2 bislang ungenutztes Gas einem technischen Gasspeicher zu entnehmen. Stattdessen wird das zur Einstellung der Atmosphäre A1 und A2 notwendige Gas zwischen Schleusenkammer und Puffertank hin und her verfrachtet und somit vorteilhaft eine große Menge an Frischgas eingespart.

In einer bevorzugten Durchführungsform des erfindungsgemäßen Verfahrens erfolgt zwischen der Übergabe des Substrats an die Bearbeitungskammer (Schritt c) und der entgegengesetzten Gasrückleitung (Schritt d) die Bearbeitung des Substrats und dessen Rückgabe an die Schleusenkammer. Anschließend wird das Substrat, nach der Wiederherstellung der Atmosphäre A1 in der Schleusenkammer (Schritt d) und vor dem Einschleusen eines neuen Substrats (Schritt a), aus der Schleusenkammer und in die Ausgangsatmosphäre A0 ausgetragen. Diese Durchführungsform ermöglicht somit vorteilhaft einen diskontinuierlichen Betrieb, wobei die Bearbeitungskammer über dieselbe Schleusenkammer be- und entladen wird.

In einer ebenfalls bevorzugten Durchführungsform des erfindungsgemäßen Verfahrens wird eine weitere, der Bearbeitungskammer nachgeordnete Schleusenkammer als Puffer für die erste Schleusenkammer genutzt. Dabei erfolgt die Bearbeitung des Substrats sowie dessen anschließende Übergabe an die weitere Schleusenkammer zwischen der entgegengesetzten Gasrückleitung (Schritt d) und der Gashinleitung (Schritt b) des darauf folgenden Zyklus. Die Übergabe an die weitere Schleusenkammer erfolgt somit bei Atmosphäre A1 in der ersten und Atmosphäre A2 in der weiteren Schleusenkammer. Der Austrag des Substrats aus der weiteren Schleusenkammer in eine Umgebung mit Ausgangsatmosphäre A0 erfolgt anschließend zwischen der Gashinleitung (Schritt b) und der Übergabe des nächsten Substrats an die Bearbeitungskammer (Schritt c) bei entgegengesetzten Atmosphären. Diese Durchführungsform des Verfahrens ermöglicht vorteilhaft einen kontinuierlichen Betrieb, wobei das Substrat durch verschiedene, über Gasleitungen miteinander verbundene Schleusenkammern in die Bearbeitungskammer ein- und ausgeleitet wird.

Besonders bevorzugt handelt es sich bei der Atmosphäre A0 um Luft, bei der Atmosphäre A1 um Inertgas und bei den Atmosphären A2 und A3 um Vakuum. Somit wird das Substrat bevorzugt aus der Facility, bspw. einem Reinraum, in eine mit Inertgas gefüllte Schleusenkammer eingebracht. Die Schleusenkammer wird anschließend evakuiert, bevor das Substrat an die ebenfalls evakuierte Bearbeitungskammer übergeben wird. Die Evakuierung der Schleuse erfolgt dabei erfindungsgemäß durch simultanes Befüllen eines Pufferspeichers. Der Pufferspeicher war bevorzugt bereits bei der Einschleusung des Substrats evakuiert. Im diskontinuierlichen Betrieb folgt der Bearbeitung die Rückübergabe des Substrats in die erste evakuierte Schleuse, deren Flutung mit dem aus dem Puffer rezyklierten Inertgas und der Austrag des Substrats in die Facility. Im kontinuierlichen Betrieb erfolgt, bevorzugt während der Bearbeitung, die Flutung der ersten Schleuse mit dem aus der weiteren Schleuse rezyklierten Inertgas. Dabei wird die weitere Schleuse evakuiert und steht so zur Aufnahme des bearbeiteten Substrats zur Verfügung. Anschließend wird die weitere Schleusenkammer mit dem aus der ersten Schleuse evakuierten Inertgas geflutet, so dass das bearbeitete Substrat ausgetragen und die erste Schleuse mit einem neuen Substrat bestückt werden kann. Die Güte des einzustellenden Vakuums hängt von dem im Bearbeitungsprozess erforderlichen Vakuum ab. Hier und im Folgenden bezeichnet Vakuum somit Feinvakuum, Hochvakuum oder Ultrahochvakuum. Als Inertgas werden hier und im Folgenden alle Edelgase eingesetzt, bevorzugt wird Argon und besonders bevorzugt wird Stickstoff eingesetzt.

Ebenfalls bevorzugt ist eine Verfahrensvariante bei der es sich bei Atmosphäre A0 um Vakuum, bei Atmosphäre A1 um Vakuum und bei den Atmosphären A2 und A3 um Inertgas handelt. Hierbei wird das Substrat in einer evakuierten Transportvorrichtung, einem Carrier, in die erste, ebenfalls evakuierte Schleusenkammer eingebracht. Anschließend erfolgt die Flutung der ersten Schleusenkammer mit einem Puffertank entnommenen Inertgas, bspw. Stickstoff oder Argon, das stofflich der Inertgas-Atmosphäre der folgenden Bearbeitungskammer gleicht, und die Übergabe an die Bearbeitungskammer. Im diskontinuierlichen Betrieb folgt der Substratbearbeitung dessen Rückführung in die Schleusenkammer, deren Entladung in den Puffer und der Substrataustrag unter Vakuum und im Carrier. Im kontinuierlichen Betrieb folgt der Übergabe des Substrats an die Bearbeitungskammer die Evakuierung der ersten Schleusenkammer. Dadurch wird die weitere Schleusenkammer mit Inertgas geflutet und steht zur Aufnahme des bearbeiteten Substrats zur Verfügung. Gleichzeitig kann die evakuierte erste Schleusenkammer mit einem neuen Substrat bestückt werden.

Wie beschrieben, werden stofflich verschiedene Atmosphären A1 und A2 bevorzugt mittels der gerichteten Gashinleitung und der gerichteten Gasrückleitung zumindest annähernd vollständig zwischen Schleusenkammer und Puffer ausgetauscht. Dabei bewirkt ein Befüllen des Puffers die Evakuierung der Schleuse und umgekehrt. Es treten bevorzugt nur geringe und besonders bevorzugt keine Druckverluste auf. In einer ebenfalls bevorzugten Durchführungsform handelt es sich bei A1 und A2 um stofflich identische Atmosphären, die mittels gerichteter Gasleitung nur teilweise zwischen Schleusenkammer und Puffertank ausgetauscht werden. Dies ermöglicht die Einstellung optimaler Druckverhältnisse zwischen den Schleusenkammern und der Bearbeitungskammer oder der Facilty bzw. des Carriers. Besonders bevorzugt handelt es sich in dieser Verfahrensvariante bei den Atmosphären A1 und A2 um Inertgas, wobei durch Einstellung geeigneter Druckverhältnisse den Eintrag von Fremdpartikeln in die Bearbeitungskammer minimiert wird.

Besonders bevorzugt wird der Eintrag von Fremdpartikeln vermieden, indem der Druck in der Schleusenkammer stets größer ist als der Druck in der Umgebung, bspw. in der Facility oder dem Carrier, und der Druck in der Bearbeitungskammer stets größer ist als der Druck in der Schleusenkammer. Dies gilt in gleicher Weise für die Verwendung stofflich verschiedener Atmosphären A0, A1 und A2. Die Drücke unterscheiden sich dabei vorzugsweise maximal um einige Millibar, bevorzugt um maximal 10 mbar und besonders bevorzugt um maximal 5 mbar. Sobald der Druck in Schleusenkammer oder Puffertank den Atmosphärendruck A0 zuzüglich dieser definierten zulässigen Druckabweichungen übersteigt, öffnet sich ein in der Abgasseite der Vakuumpumpe angeordnetes Rückschlagventil. Somit werden Druckspitzen vorteilhaft vermieden.

In der zuletzt beschriebenen Durchführungsform sind Gasverluste während des Ein- und Ausschleusens schon aufgrund der Druckgefälle nicht vermeidbar. In einer bereits anfänglich vorhandenen (Inert-) Gasmenge, werden Druckverluste aufgrund der Druckgefälle bevorzugt durch Zuführen zusätzlichen Gases in die Schleuse und/oder den Puffer ausgeglichen. Gleiches gilt für Druckverluste, die bei der gerichteten Gasleitung erfolgen. Zusätzliches Gas wird Schleusenkammer und Puffer bevorzugt aus mindestens einem Inertgas-Reservoir zugeleitet, wobei ein gemeinsames Reservoir für Schleusen und Puffer oder jeweils einzeln zugeordnete Reservoire vorgesehen sind. Somit werden Inertgas-Verluste, auch solche über das Rückschlagventil, ausgeglichen und vorteilhaft ein zyklischer Betrieb von Be- und Entladen von Schleusenkammer und zugeordnetem Puffertank ermöglicht.

Die gerichtete Gasleitung erfolgt bevorzugt mittels einer Vakuumpumpe, besonders bevorzugt mittels einer trockenlaufenden Vakuumpumpe. Dabei sind Schleuse und Puffer über geeignet gasdichte Rohrleitungen und die Pumpe miteinander verbunden, wodurch Gas entlang der Rohrleitungen und gegen ein Druckgefälle transportiert werden kann.

In einer bevorzugten Durchführungsform wird zum Fluten einer Schleusenkammer mit Inertgas aus einem Puffertank und dem Entladen der Schleusenkammer in diesen Puffertank dieselbe Vakuumpumpe eingesetzt. In einer besonders bevorzugten Durchführungsform wird auch zum Ausgleich von Druckverlusten mit zusätzlichem Gas, insbesondere Inertgas, aus einem Inertgas-Reservoir dieselbe Vakuumpumpe eingesetzt. Weiterhin bevorzugt ist an der Abgasseite der Vakuumpumpe eine regelbare Drosselklappe angeordnet. Mit dieser lässt sich unabhängig vom jeweiligen Füllstand der an die Abgasseite angeschlossenen Schleusenkammer bzw. des angeschlossenem Puffertanks ein konstanter Druck an der Vakuumpumpe einstellen. Somit kann die Vakuumpumpe vorteilhaft mit konstanter Pumpleistung betrieben werden, was die Lager schont und somit zu einem kontaminationsfreien Vakuum beiträgt.

Um die Vakuumpumpe zu entlasten ist weiterhin eine Gasleitung bevorzugt, die spontan aufgrund von Druckunterschieden zwischen Schleusenkammer und Puffer erfolgt. Dabei erfolgt die spontane, gerichtete Gasleitung stets nur bis zur Einstellung eines Gleichgewichts, wonach die Pumpe den aktiven Transport übernimmt.

In einer besonders bevorzugten Durchführungsform des erfindungsgemäßen Verfahrens erfolgt unmittelbar vor dem durch die Vakuumpumpe vermittelten Fluten einer Schleusenkammer mit Inertgas ein Druckausgleich zwischen Schleusenkammer und Puffertank über eine ventilgesteuerte Bypass-Leitung. Gleichsam bevorzugt wird diese Bypass-Leitung, bzw. mindestens ein in dieser Leitung befindliches Ventil, unmittelbar vor der Inertgas-Entladung von einer Schleusenkammer in einen Puffertank geöffnet, um so einen spontanen Druckausgleich in beiden Gefäßen zu bewirken. Vorteilhaft werden so die Vakuumpumpe, insbesondere deren Lager, geschont und Betriebskosten eingespart.

Ebenfalls bevorzugt wird eine Durchführungsform des erfindungsgemäßen Verfahrens, wobei die Evakuierung von Schleusenkammer oder Puffertank durch mehrstufiges Abpumpen erfolgt. In der ersten Stufe wird dabei mittels der bereits beschriebenen Vakuumpumpe das Gas durch Gashinleitung oder Gasrückleitung verfrachtet und somit Puffertank oder Schleusenkammer entladen. Zur Einstellung eines Hochvakuums erfolgt anschließend ein weiteres Abpumpen mit einer saugstarken Turbopumpe gegen das Abgassystem, bis der gewünschte Schleusdruck eingestellt ist.

Im zyklischen Betrieb wird zur Flutung einer Schleusenkammer eingesetztes Inertgas nahezu vollständig, bevorzugt zu 90% und besonders bevorzugt zu 95% zurückgewonnen. Somit werden große Mengen an Inertgas sowie damit verbundene Kosten eingespart. Aufgrund des fehlenden Kostendrucks ist eine voluminösere Ausgestaltung von Schleusenkammern möglich, was vorteilhaft für die Bearbeitung größerer Substrate ist und die Möglichkeiten zur Installation von Einbauten in die Schleusen erweitert.

Ebenfalls gelöst wird die erfindungsgemäße Aufgabe durch eine Anordnung zur Rückgewinnung von Inertgas aus einer Schleusenkammer, aufweisend mindestens eine Bearbeitungskammer zur Bearbeitung eines Substrats, mindestens eine mit der Bearbeitungskammer verbindbare Schleusenkammer, mindestens einen Puffertank zur Speicherung von Gas und mindestens eine Vakuumpumpe, wobei jede Schleusenkammer über eine Vakuumpumpe mit mindestens einem Puffertank ventilgesteuert verbunden ist und Gas aus der Schleusenkammer mittels der Vakuumpumpe in den Puffertank und wieder zurück pumpbar ist. Bevorzugt ist das Gas aus der Schleusenkammer zumindest annähernd verlust- und verschmutzungsfrei in den Puffertank und wieder zurück pumpbar.

Die mindestens eine Bearbeitungskammer dient der Bearbeitung, insbesondere der Beschichtung eines Substrats unter der Bearbeitungsatmosphäre A3. In einer bevorzugten Ausführungsform handelt es sich bei der Bearbeitungskammer um eine Kammer zur PECVD- oder PVD-Beschichtung.

Die mindestens eine Schleusenkammer ist der mindestens einen Bearbeitungskammer vor-, nach- oder, im Falle mehrerer Bearbeitungskammern, zwischengeschaltet und dient der Einführung eines Substrates in die Bearbeitungskammer unter Erhaltung der dort herrschenden Atmosphäre. Die Schleusenkammer weist dazu mindestens eine gasdicht verschließbare Verbindungsöffnung zur Bearbeitungskammer und mindestens eine gasdicht verschließbare Zuführöffnung auf. Ein Substrat ist mittels eines geeigneten Transportsystems über die Zuführöffnung in die Schleusenkammer und von dort über die Verbindungsöffnung in die Bearbeitungskammer einbringbar. Bevorzugt sind an eine Schleusenkammer mehrere Bearbeitungskammern oder an eine Bearbeitungskammer mehrere Schleusenkammern angeschlossen. Besonders bevorzugt sind an eine Schleusenkammer mehrere Puffertanks angeschlossen, um in der Schleuse ein Vakuum und verschiedene Inertgas-Atmosphären wechselbar einzustellen.

Erfindungsgemäß ist der mindestens eine Puffertank zur Speicherung von Gas geeignet und über Zu- und Ableitungen regelbar mit mindestens einer Schleusenkammer verbunden, wobei Gas entlang dieser Verbindungen mittels der Vakuumpumpe gefördert wird. Eine Schleusenkammer weist mindestens einen Gasabgang zu einem Puffertank sowie mindestens einen, von diesem Puffertank kommenden Gaszugang auf. Die Regelung der Gasflüsse entlang von Gaszu- und Gasabgängen erfolgt über Ventile sowie über die Vakuumpumpe. Es ist jeweils mindestens ein Ventil entlang jedes Gasabgangs und Gaszugangs angeordnet Erfindungsgemäß weisen Schleusenkammer sowie Puffertank weiter eine Gaszufuhr auf, über die sie mit Inertgas aus einem Inertgas-Reservoir befüllbar sind. Diese Gaszufuhr weist dabei mindestens ein regelbares Ventil auf, über das der Fluss des Inertgases gesteuert wird.

Die erfindungsgemäße Vorrichtung erlaubt vorteilhaft die Rückgewinnung von Inertgas aus den Schleusenkammern einer Bearbeitungsanlage für Solarmodule oder andere Halbleiterfabrikate, wobei nahezu das gesamte Inertgas rückgewonnen wird. Von einer Schleusenkammer in einen Puffertank abgeleitetes Gas steht dabei erneut zur Erzeugung einer temporären Schutzatmosphäre in der Schleusenkammer zur Verfügung. Sind in einer erfindungsgemäßen Anordnung mehrere Schleusenkammern vorhanden, so sind die Inertgase nach Sorten getrennt in Puffertanks abzuführen, wobei gleichartiges Inertgas, bspw. Stickstoff oder Argon, aus mehreren Schleusenkammern in einen Puffertank geleitet werden kann. Vorteilhaft ermöglicht die erfindungsgemäße Vorrichtung die Einsparung großer Mengen Inertgas und der dafür notwendigen Mittel und erhöht so die Wirtschaftlichkeit der unter Schutzatmosphäre erfolgenden Bearbeitung.

In einer bevorzugten Ausführungsform des erfindungsgemäßen Verfahrens weisen verbundene Puffertanks und Schleusenkammern jeweils gleiche Volumen auf, wodurch die Gasableitung aus Schleusenkammer in Puffertank ohne Kompression des Inertgases erfolgt. Vorteilhaft sind dadurch keine weiteren Aggregate, bspw. Gasverdichter, nötig. Zudem unterliegen die Puffertanks somit keinen auf Druckbehälter bezogenen Vorschriften, insbesondere nicht der Europäischen Druckbehälterrichtlinie und müssen somit nicht als zertifiziert geschweißte Tanks ausgebildet sein und jährlich vom TÜV kontrolliert werden. Somit ergebt sich eine weitere Kostenersparnis in der Herstellung und Wartung. Wird Inertgas aus mehreren Schleusenkammern in einen gemeinsamen Puffertank geleitet, so weist dieser Puffertank ein Volumen gleich der Summe der Volumen der verbundenen Schleusenkammern auf. Werden mehrere Schleusenkammern sequentiell in einen gemeinsamen Puffertank entladen, weist dieser vorteilhaft ein zur Aufnahme des jeweils gleichzeitig gepufferten Inertgases geeignetes Volumen auf.

Um sicherzustellen, dass sich in den Puffertanks kein Überdruck aufbaut, ist an der der Abgasseite der Vakuumpumpe vorzugsweise ein Rückschlagventil angeordnet. Kommt es zu einem Anstieg des Inertgas-Drucks im Abgasstrang der Vakuumpumpe und der momentan damit verbundenen Schleusenkammer bzw. des Puffertanks über Atmosphärendruck zuzüglich zulässiger Abweichungen, öffnet das Ventil und das geförderte Inertgas wird an die Facility, die Außenluft, einen Gasendspeicher oder eine Gasaufbereitungsanlage abgegeben. Somit wird ein Überdruck in der Schleusenkammer oder dem Puffertank mit hoher Sicherheit vermieden, insbesondere beim sequentiellen Entladen mehrerer Schleusenkammern in einen Puffertank. Durch die sichere Vermeidung eines Überdrucks auf der Abgasseite werden Lastspitzen der Vakuumpumpe beim Leerpumpen der Schleusenkammer sowie Strömungsspitzen beim Fluten der Schleusenkammer vorteilhaft vermieden.

Bei den eingesetzten Vakuumpumpen handelt es sich bevorzugt um eine trockenlaufende Vakuumpumpe, die zur Erzeugung eines von Öl- und Betriebsflüssigkeiten unbelasteten Vakuums geeignet ist und weiterhin keine Öl- und Betriebsmittelreste in das zu fördernde Medium abgibt. Die Kontaminationsfreiheit des Inertgases stellt vorteilhaft dessen dauerhafte Wiederverwendbarkeit sicher. Besonders bevorzugt werden trocken arbeitende Schraubenspindelpumpen oder Wälzkolbenpumpen eingesetzt.

Um die Gefahr der Emission von Verunreinigungen durch die eingesetzte Vakuumpumpe weiter zu minimieren, ist an deren Abgasseite bevorzugt eine regelbare Drosselklappe angeordnet. Mit der Drosselklappe wird beim Entladen der Schleusenkammer oder des Puffertanks an der Abgasseite der Vakuumpumpe ein konstanter, vom Füllstand des zu beladenen Puffertanks oder der Schleusenkammerunabhängiger Druck eingestellt. Durch die Vermeidung von Druckwechseln an der Abgasseite werden vorteilhaft Lastwechsel der Pumpe vermieden und somit deren Lager geschont.

Bevorzugt sind in Puffertank und Schleusenkammer Manometer zur Messung des Drucks vorgesehen. Dies erlaubt vorteilhaft die Regelung der Drosselklappe anhand der tatsächlich herrschenden Druckverhältnisse.

In einer ebenfalls bevorzugten Anordnung besteht zwischen mittels Vakuumpumpe verbundenen Schleusenkammern und Puffertanks zusätzlich eine ventilgesteuerte Bypass-Verbindung, die einen Gasaustausch ohne den Einsatz von Pumptechnik ermöglicht. Der Bypass dient somit dem spontanen Druckausgleich zwischen verbundenen Schleusenkammern und Puffertank, der eine vorteilhafte Reduktion der energetischen Kosten des erfindungsgemäßen Verfahrens ermöglicht. Weiterhin vorteilhaft werden für die Schaltung der Bypass-Verbindung Ventile mit Softpumpfunktion benutzt, um eine Steuerung des Gasausgleichs zu ermöglichen.

Bevorzugt sind der Puffertank und/oder die Schleusenkammer mit mindestens einem Inertgas-Reservoir verbunden und von diesem aus unabhängig vom Gaszugang aus der Schleusenkammer bzw. dem Puffertank mit Inertgas befüllbar. Somit sind Leitungsverluste sowie das über das Rückschlagventil ausgetretene Inertgas vorteilhaft ausgleichbar. Die Verluste werden bevorzugt über Druckmessungen in Schleusenkammer und Pufferkammer bestimmt.

Ebenfalls Gegenstand der Erfindung ist die Verwendung einer erfindungsgemäßen Vorrichtung zur Rückgewinnung von Inertgas aus mindestens einer Schleusenkammer im erfindungsgemäßen Verfahren. Somit werden vorteilhaft die Menge des zur Flutung von Schleusenkammern eingesetzten Inertgases sowie die damit verbundenen Kosten signifikant reduziert.

Im Folgenden wird die Erfindung anhand eines Ausführungsbeispiels sowie einer Figur näher erläutert, ohne darauf beschränkt zu sein. Dabei zeigt:

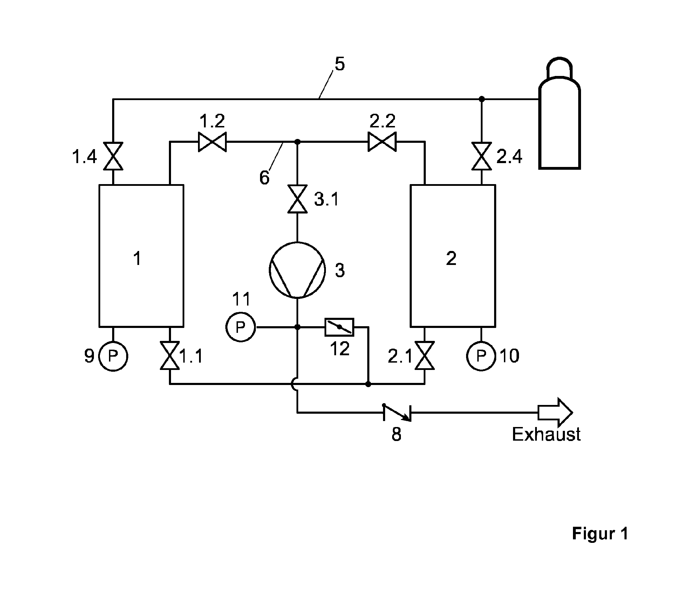

**Figur 1****:** ein schematisches Blockschaltbild einer erfindungsgemäßen Anordnung.

In **Fig.** 1 ist ein schematisches Blockbild einer erfindungsgemäßen Anordnung für die Stickstoffrückgewinnung gezeigt. Dieses Blockbild wurde in Form eines Teststandes realisiert, wobei zwei Puffer **1**,**2** mit einem Nennvolumen von jeweils 1m³ zusammengeschalten wurden und der Puffer **1** die Schleusenkammer **1** simuliert.

Die Schleusenkammer ist mit einem Gasabgang **6** über die Vakuumpumpe **3** mit dem Puffertank **2** verbunden. Weiterhin führt vom Puffertank **2** über die Vakuumpumpe **3** ein Gaszugang **7** in die Schleusenkammer. Die Verrohrung der Pumpe **3** ist dabei jeweils in Edelstahl, saugseitig mit DN 160 und abgasseitig mit DN 40, sowie mit entsprechenden Ventilen ausgeführt.

Die Ventile **1.2** und **2.2** sind jeweils als Ventil mit Softpumpfunktion ausgeführt. Zunächst wurden die Schleusenkammer **1** und der Puffer **2** getrennt bis zu einem Druck von 5 * 10-3 mbar evakuiert. Anschließend wurde der Puffer **2** mit Stickstoff bis zum Atmosphärenschaltpunkt belüftet. Die Nachflutung erfolgte im Teststand mit einer Überdruckvorgabe (z.B. Schaltpunkt + 50mbar) oder alternativ nach einer Zeit. Die Druckmessung in der Schleusenkammer erfolgte mit einer Manometer **9**, ausgeführt als Mehrbereichsmessröhre des Typs MKS-974B.

Nach dem Initialisieren wird das Ventil **3.1** geschlossen und die Hauptventile **1.2** und **2.2** sowie **1.1** geöffnet. Nach der Zeit für den Druckausgleich, schließt das Ventil **1.2** und zeitgleich öffnet das Ventil **3.1**. Das Inertgas (Stickstoff) wird vom Puffer **2** über Ventil **2.2** - Ventil **3.1** - Pumpe 3 **-** Ventil **1.1** gepumpt. Bei der Pumpe **3** handelt es sich um eine Vakuumpumpe. Mit dem Erreichen der Schaltpunkte Atmosphäre in der Schleusenkammer **1** und Vakuum (10mbar) im Puffertank **2** schließt das Ventil **1.1** und über das Ventil **1.4** startet die Nachflutung mit Stickstoff der Reinheit 2.8 für die Schleusenkammer **1** aus einem ersten Inertgas-Reservoir über 16 mm Festo Schläuche. Die Druckmessung im Puffertank **2** erfolgte über ein kapazitives Manometer **10**.

Zum Abpumpen der Schleusenkammer **1** wird das Ventil **3.1** geschlossen und die Ventile **1.2** und **2.2** sowie das Ventil **2.1** geöffnet. Nach der Zeit für den Druckausgleich schließt das Ventil **2.2** und zeitgleich öffnet das Ventil **3.1.** Das Inertgas (Stickstoff) wird dann von der Schleusenkammer **1** über das Ventil **1.2** - Ventil **3.1** - Pumpe **3** - Ventil **2.1** gepumpt. Mit dem Erreichen der Schaltpunkte Atmosphäre im Puffertank **2** und Vakuum (10mbar) in der Schleusenkammer **1** schließt das Ventil **2.1** und über das Ventil **2.4** startet die Nachbelüftung für den Pufferspeicher aus dem zweiten Inertgas-Reservoir.

Bei der Nachbelüftung wird das auf Grund von Druckstößen am Abgasrückschlagventil **8** (Kugelrückschlagventil) verlorene Medium nachgefüllt. Für 1000 Zyklen wurden etwa 2 m³ Stickstoff benötigt. Mit der Verringerung des Abstandes der Vakuumpumpe **3** zur Schleusenkammer **1** kann die Abpumpzeit verringert werden. Wenn dies nicht möglich ist, sollte die Abgasleitung **6** zum Puffertank **2** so kurz wie möglich sein.

Die Zeit des Flutens der Schleusenkammer **1** liegt bei etwa 21 Sekunden, das Evakuieren der Schleusenkammer **1** bis 1 mbar nimmt etwa 31 Sekunden in Anspruch. Die Stickstoffeinsparung beträgt 95%.

Mit dem Teststand konnte keine Verunreinigung des Mediums (Stickstoff) nach 1000 Zyklen, also dem 500-maligem Abpumpen und Belüften der Schleusenkammer **1** festgestellt werden.

Mit Hilfe eines Massenspektrometers, wurden an der Saugleitung von Gasabgang **6** die Restgase analysiert. Dabei kam es im Laufe der 1000 Zyklen zu keinem Anstieg von Partikeln zwischen der Masse 15 <= u <= 150. Lediglich für die Massen des Stickstoffes (u = 14 [N] und u = 28 [N2]) findet ein Wechsel der Konzentration in Abhängigkeit des Abpumpens des Mediums statt.

Unter Einsatz einer gebrauchten Pumpe mit einer Laufzeit von über einem Jahr und ca. 2600 Betriebsstunden wurde der Test mit etwa 2500 Zyklen wiederholt. Es konnten erneut keinerlei Verunreinigungen während des Durchlaufs erfasst werden.

### Bezugszeichen

- 1: - Schleusenkammer
- 1.1: - Ventil
- 1.2: - Ventil
- 1.4: - Ventil
- 2: - Puffertank
- 2.1: - Ventil
- 2.2: - Ventil
- 2.4: - Ventil
- 3: - Vakuumpumpe
- 3.1: - Ventil
- 5: - Gaszufuhr, ventilgesteuert
- 6: - Gasabgang, ventilgesteuert
- 7: - Gaszugang, ventilgesteuert
- 8: - Abgasrückschlagventil
- 9: - Manometer
- 10: - Manometer
- 11: - Manometer
- 12: - Drosselklappe

## Patentansprüche

1. Verfahren zur Inertgas - Rückgewinnung, **aufweisend** die folgenden Verfahrensschritte
a) Einschleusen eines Substrates aus einer Atmosphäre A0 in eine Schleusenkammer (1) mit der Atmosphäre A1,
b) gerichtete Gashinleitung zwischen Schleusenkammer (1) und einem Puffer (2) und dadurch Einstellung von Atmosphäre A2 in der Schleusenkammer (1),
c) Übergabe des Substrates an eine Bearbeitungskammer mit Atmosphäre A3, wobei die Zusammensetzung der Atmosphären A2 und A3 identisch ist,
d) entgegengesetzte Gasrückleitung zwischen Schleusenkammer (1) und Puffer (2) und dadurch Einstellung der Atmosphäre A1 in der Schleusenkammer (1),
e) Wiederholung der Schritte a) - d).

2. Verfahren nach Anspruch1, **dadurch gekennzeichnet, dass**
i) zwischen Schritt c) und d) die Bearbeitung des Substrats und dessen Rückgabe an die Schleusenkammer (1) und
ii) zwischen Schritt d) und e) der Austrag des Substrats aus der Schleusenkammer (1) in die Ausgangsatmosphäre erfolgt.

3. Verfahren nach Anspruch1, **dadurch gekennzeichnet, dass**
i) zwischen Schritt d) und dem Schritt b) der folgenden Wiederholung die Bearbeitung des Substrats und dessen Übergabe an eine weitere Schleusenkammer und
ii) und in der folgenden Wiederholung zwischen Schritt b) und Schritt c) der Austrag des Substrats aus der weiteren Schleusenkammer in die Ausgangsatmosphäre erfolgt, wobei
iii) die weitere Schleusenkammer als Puffer eingesetzt wird.

4. Verfahren nach einem der Ansprüche 1 bis 3, **dadurch gekennzeichnet, dass**
i) es sich bei der Atmosphäre A0 um Luft,
ii) bei der Atmosphäre A1 um Inertgas und
iii) bei den Atmosphären A2 und A3 um Vakuum handelt.

5. Verfahren nach einem der Ansprüche 1 bis 3, **dadurch gekennzeichnet, dass**
i) es sich bei der Atmosphäre A0 um Vakuum,
ii) bei der Atmosphäre A1 um Vakuum und
iii) bei den Atmosphären A2 und A3 um Inertgas handelt.

6. Verfahren nach einem der vorangehenden Ansprüche, **dadurch gekennzeichnet, dass** in den Schritten b) und d)
i. stofflich verschiedene Atmosphären A1 und A2 zumindest annähernd vollständig zwischen Schleusenkammer (1) und Puffer (2) ausgetauscht werden oder
ii) stofflich identische Atmosphären teilweise zwischen Schleusenkammer (1) und Puffer (2) verlagert werden.

7. Verfahren nach einem der vorangehenden Ansprüche, **dadurch gekennzeichnet, dass**
i) der Druck p(A0) stets kleiner ist als der Druck p(A1) und
ii) der Druck p(A2) stets kleiner ist als der Druck p(A3).

8. Verfahren nach einem der vorangehenden Ansprüche, **dadurch gekennzeichnet, dass** beim Ein- und Ausschleusen sowie der Gashin- oder -rückleitung auftretende Verluste durch Zuleitung von Gas aus einem Reservoir ausgeglichen werden.

9. Verfahren nach einem der vorangehenden Ansprüche, **dadurch gekennzeichnet, dass**
i) die Gashin- oder -rückleitung in den Schritten b) und d) mittels einer Vakuumpumpe (3) oder
ii) entlang eines Druckgefälles spontan erfolgt.

10. Anordnung zur Inertgas - Rückgewinnung, **aufweisend**
- eine Bearbeitungskammer zur Bearbeitung eines Substrats,
- mindestens eine mit der Bearbeitungskammer verbindbare Schleusenkammer (1),
- mindestens einen Puffertank (2) zur Speicherung von Gas und
- mindestens eine Vakuumpumpe (3), **wobei**
- jede Schleusenkammer (1) über eine Vakuumpumpe mit mindestens einem Puffertank (2) ventilgesteuert verbunden ist und
- Gas aus der Schleusenkammer (1) mittels der Vakuumpumpe in den Puffertank (2) und wieder zurück pumpbar ist.

11. Anordnung nach Anspruch 10, wobei mindestens eine Schleusenkammer (1)
- mit mindestens einem ersten Inertgas-Reservoir über eine ventilgesteuerte Gaszufuhr (5) und ,
- mit mindestens einem Puffertank (2) über einen ventilgesteuerten Gasabgang (6) und einen ventilgesteuerten Gaszugang (7) über die Vakuumpumpe (3) verbunden ist.

12. Anordnung nach einem der Ansprüche 10 und 11, **dadurch gekennzeichnet, dass** ein Puffertank (2) und die jeweils verbundene Schleusenkammer (1) ein gleiches oder annähernd gleiches Volumen besitzen.

13. Anordnung nach einem der Ansprüche 10 bis 12, **dadurch gekennzeichnet, dass** an der Abgasseite mindestens einer Vakuumpumpe (3) ein Rückschlagventil (8) und/oder eine Drosselklappe (12) angeordnet ist.

14. Anordnung nach einem der vorangehenden Ansprüche, **dadurch gekennzeichnet, dass** es sich bei der mindestens einen Vakuumpumpe (3) um eine trockenlaufende Vakuumpumpe (3) handelt.

15. Anordnung nach einem der vorangehenden Ansprüche, **dadurch gekennzeichnet, dass** mindestens eine Schleusenkammer (1) und mindestens ein Puffertank (2) über einen ventilgesteuerten Bypass verbindbar sind.

16. Anordnung nach einem der vorangehenden Ansprüche, **dadurch gekennzeichnet, dass** mindestens ein Puffertank (2) mit mindestens einem Inertgas-Reservoir verbunden ist.

17. Verwendung einer Anordnung nach einem der Ansprüche 10 bis 16 zur Durchführung eines Verfahrens nach einem der Ansprüche 1 bis 9.
